Europäisches Patentamt

European Patent Office

Office européen des brevets

(11) Publication number: **0 402 520**
**A2**

## EUROPEAN PATENT APPLICATION

(21) Application number: 89114658.1

(22) Date of filing: 08.08.89

(51) Int. Cl.5: **H01L 21/00**

(30) Priority: 16.06.89 JP 152157/89

(43) Date of publication of application:
**19.12.90 Bulletin 90/51**

(84) Designated Contracting States:
**DE FR GB IT**

(71) Applicant: ENYA MFG. CO., LTD.
8-36, Yoshinodai 2-chome
Kawagoe-shi Saitama-ken(JP)

(72) Inventor: Suzuki, Shizuo
20, Nishiwake-cho 1-chome
Oume-shi Tokyo(JP)

(74) Representative: Klingseisen, Franz, Dipl.-Ing.
et al
Dr. F. Zumstein Dipl.-Ing. F. Klingseisen
Bräuhausstrasse 4
D-8000 München 2(DE)

(54) **Automatic wafer adhering device.**

(57) A wafer adhering device for automatically adhering wafers on a polishing plate for polishing the surface of the wafers.

The wafers are taken out from a wafer cassette one by one, and transferred to an adhesive coating section by a carrying means. The surface of the wafers are coated by the adhesive wax in the coating section. After the adhesive coated wafers are carried out from the coating section by the carrying means, the wafers are taken out from the carrying means and are reversed the surfaces thereof by a reverse chuck means. The polishing plate is waited on the position where the reversed wafers are arrived, and the wafers are adhered onto the surface of the polishing plate.

FIG. I

## Automatic Wafer Adhering Device

### Background of the Invention

#### (1) Field of the invention

The present invention relates to a wafer adhering device for mounting wafers on a polishing plate, more particularly, relates to a wafer adhering device for coating adhesive agent on the upper surface of the wafers and adhering the wafers onto a polishing plate by effect of such adhesive agent automatically.

#### (2) Background information

In order to treat thin wafers or obtain wafers which have flatness, a plurality of wafers are adhered on a polishing plate and are polished by mounting the polishing plate in the polishing machine.

For example, the aforesaid treatment has been effected by coating an adhesive wax manually on the plate made of ceramics, Pyrex (trademark) or the like, and mounting manually the wafers thereon, and/or by coating an adhesive wax on each of the wafers manually and mounting each of the wafers individually. These treatments have defects due to manual work to be involved such as that it was difficult to prevent adhesion of dust even if the work was perfomred in dust-free section and/or it was difficult to mount wafers on the polishing plate in the same level position as performed by machinery. Therefore, work efficiency was not satisfactory,and accordingly there also existed a problem of treatment ability. On the other hand, the holding part of each wafer is often distorted by the heat and gives a bad influence to the wafer adhering onto a polishing plate.

### Summary of the Invention

The primary object of the present invention is to provide an automatic wafer adhering device which can adhere wafers to a polishing plate automatically without utilizing manual labor, in order to dissolve the defect as mentioned above.

Another object of the present invention is to provide a wafer adhering device which can adhesively hold wafers onto a polishing plate evenly, i.e., can minimize the variation of wax thickness and which can be polished a plurality of wafers on the polishing plate in almost uniform thickness.

The above objects of the present invention are attained by providing a wafer adhesive device comprising:

a carrying means which transfers wafers, and puts thereon one one,

a spin chuck means which is provided to permit up or down movement, receiving wafers from the carrying means during the upward movement, turning wafers at the top position, and replacing wafers to the carrying means during the downward movement,

an adhesive agent coating means which is provided at the upper portion of the spin chuck means and drips adhesive agent thereupon to the wafers,

a reverse chuck means which inverts the side of wafers on which adhesive agent is coated and removes outwardly the wafers from the carrying means, and

a means for holding the polishing plate at the predetermined place so as to adhere the wafers ejected from the carrying means in reversed position onto the surface of the polishing plate.

According to the present invention, the wafer holding part of the reverse chuck means is made of heat-proof material and the adhesive means protecting against heat transformation is provided.

The above and further objects of the present invention will become apparent from the following detailed description when read in conjunction with the accompanying drawings.

### Brief Description of the Drawings

Fig. 1 is a plane view of the wafer adhering device of the present invention.

Fig. 2 is an explanatory view showing all processes from the automatic treatment of wafers to the adhesion thereof onto the polishing plate in accordance with the present invention.

Fig. 3 is a partially exposed side elevational view of the wafer supplying section in which one of the pushing devices is omitted.

Figs. 4 through 8 show an orientation-flat aligning device, and Fig. 4 is a partially cross-sectional side elevational view showing the orientation-flat aligning device.

Fig. 5 is a plane view of the orientation-flat aligning device shown in Fig. 4. in which body portion thereof is omitted.

Fig. 6 is a cross sectional view along line A - A of Fig. 4.

Fig. 7 is a rear view of the orientation-flat aligning device in which lower portion thereof is omitted.

Fig. 8 is a side elevational view of the flange and cylinder unit for determining location of the orientation-flat aligning device in Fig. 4.

Fig. 9 is a cross sectional view of the carrying means.

Fig. 10 is a longitudinal sectional view of the carrying means shown in Fig. 9.

Fig. 11 is a partially cross sectional side elevational view of the spin chuck means and adhesive agent coating means.

Fig. 12 is an enlarged cross sectional side elevational view of the holding unit.

Fig. 13 is a partially cross sectional side elevational view of the reverse chuck means.

Fig. 14 is a plane view of the reverse chuck means shown in Fig. 13.

Description of the Preferred Embodiments

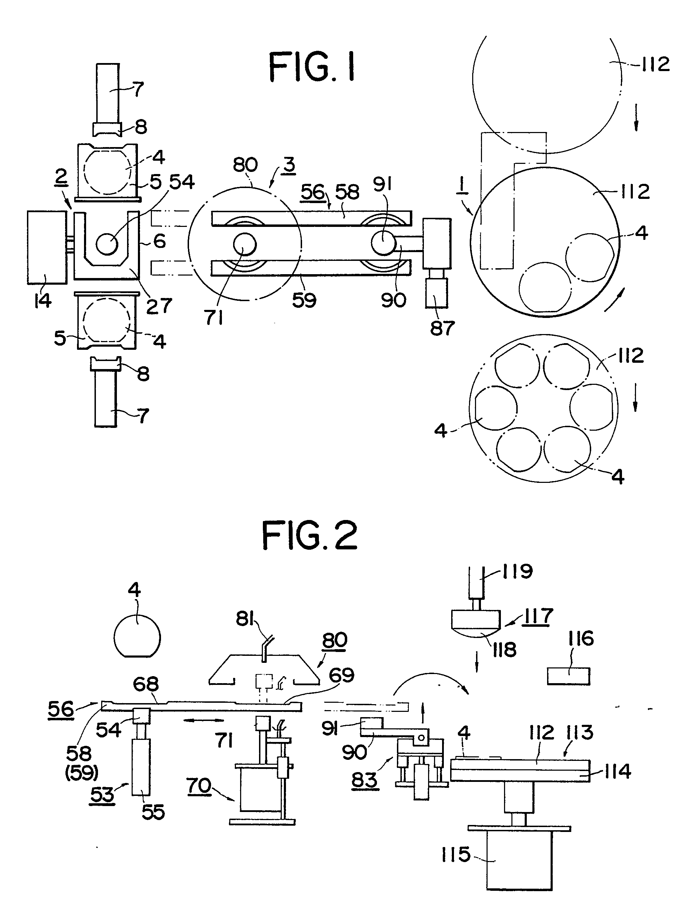

Fig. 1 and Fig. 2 are explanatory views showing entire constitution of the devices of the present invention. As shown in these figures, a wafer adhering device of the present invention has in sequence a loading section, a washing section pretreatment including a heating section after treatment including a press and cooling section and an unloading section of the polishing plate. Between the pretreatment section and after treatment section, an adhering section (1) of wafers is provided and an outer side of the adhering section (1) has a supplying section (2) for supplying wafers and a coating section (3) for applying adhesive agent on such wafers.

(Treatment of the Polishing Plate)

The aforementioned polishing plate is transferred to each processing stage in sequence order by each corresponding transfer robot respectively in which they are able to move between a predetermined range. This transference of the polishing plate may also be performed by the tact system, the conveyor system, etc., or manually.

A plurality of the polishing plates are placed on the shelf-like members thereof in a stack laid one on top of another and are tranferred from a movable loading carriage to a loading elevator. Each of the polishing plates is picked out from the shelf-like members of the plate box by a loading carrying conveyor, when the loading elevator is moved downward in succession.

The polishing plates transferred onto the carrying conveyor are routed to the washing section by the transfer robot. This washing section is provided to pre-wash the polishing plates. During the first washing the polishing plates are scrubbed using organic solvent or alcohol or the like, and during the second washing the plates are scrubbed or rinsed using pure water.

The polishing plates treated in the washing section are moved to the heating section by another transfer robot. Preferably the heating section is applied in several stages to heat them gradually. For example, during the first heating, temperature is at about 60° C, the second heating about 100° C, and the third heating about 120° C. Heating time may be varried in accordance with the nature of the polishing plate or adhesive agent, and the temperature may be also altered during each stage.

The heated polishing plate at the predetermined temperature is transferred onto the adhering section (1) by another robot. If the polishing plate has been heated higher than the predetermined temperature during the third heating, the transfer robot is programmed to remove the polishing plate apart from the heating elements until the proper temperature is attained.

The polishing plate on which a plurality of wafers are adhered at the predetermined place as mentioned below, is transferred into the press and cooling section by another transfer robot. In the press and cooling section, the polishing plate is secured by press to firmly fix the wafers onto the polishing plate, and at the same time, is cooled gradually. The first cooling, the second cooling and the third cooling are provided to cool them gradually.

If superflous adhesive agent has adhered to the wafers attached to the polishing plate, the polishing plate is cooled, washed and then transferred into the third washing, and wherein the polishing plate is washed and dried after scrubbing with organic solvent, rinsing by alcohol, blowing $N_2$ gas thereon, etc. The post-washing may be omitted if the polishing plate is free from contamination.

Thus, the polishing plate is transferred onto an unloading carrying conveyor by another transfer robot, and through the carrying conveyor each of the plates is received one by one into a plate box supported by the unloading elevator. The plate box is carried to the polishing machine by the movable unloading carriage after receiving the predetermined number of the polishing plates therein.

(Supply of Wafers)

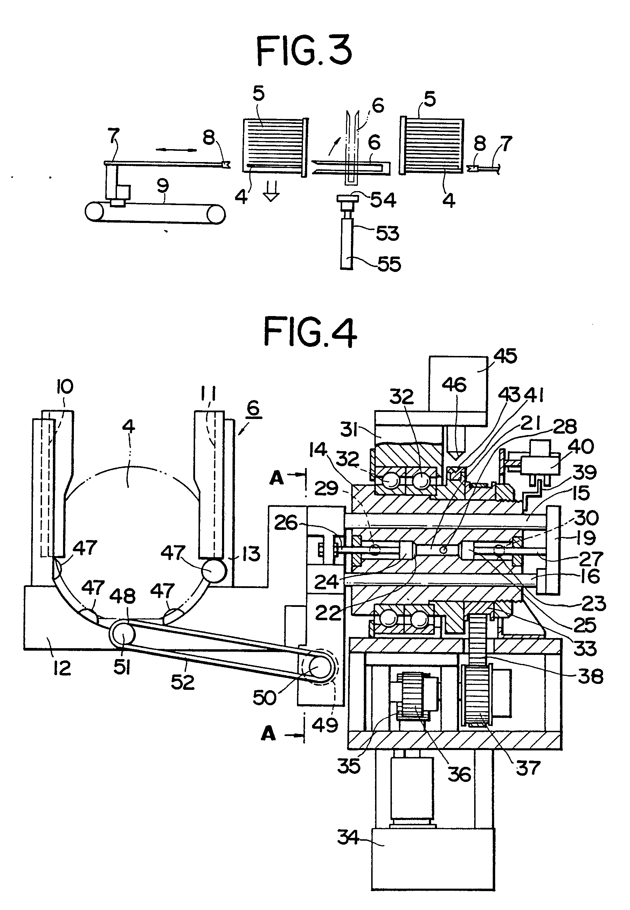

The wafer supplying section (2) is constituted as shown mainly in Fig. 3. In the drawing, a cassette (5) in which 25 pieces of wafers (4) are placed on shelves, is respectively received, stacked on piles or put in lines in the carrier boxes (not illustrated) which are provided oppositely to face each other. Between these carrier boxes, an orientation-flat aligning device (6) is provided. These carrier boxes are supported on an elevator means (not illustrated), and the elevator means causes the carrier box to move downward successively so that the wafers are successively opposed to the orientation-flat aligning device from the upper positioned wafer to the lower positioned one when ejected by a pusher (7) mentioned below.

On the side of the carrier boxes, the pushers (7) are provided respectively. The pusher (7) has a pushing plate (8) which is movable in horizontal direction and one end of the pushing plate (8) is fixed to a chain (9) which is moved by means of motor, sprockets,etc. A limit switch (not illustrated) provided at the proper position limits movement of the chain, and permits reciprocating movement of the pushing plate (8) in the predetermined range. When the pushing plate (8) is advanced, the end thereof enters into the cassette (5) through an opening at the rear face thereof and ejects the wafer (4) into the orientation-flat aligning device (6) and returns to its original position. This operation continues until all wafers placed in the casettes in one carrier box have been ejected one by one. After completion, wafers in the other carrier box are ejected in the same manner as mentioned above, by the other pusher in motion. In the meantime, empty cassettes (5) are taken out from the carrier box and new cassette filled with wafers are replaced. As mentioned above, the wafers are supplied successively into the orientation-flat aligning device one by one.

When the orientation-flat of wafers placed on the cassette is in a predetemined orientation, the orientation-flat aligning device may be omitted, and it is possible to supply wafers to a carrying means mentioned below by using other suitable means. The wafers taking out from the cassette may be supplied after washing by scrubber.

(Orientation-Flat Aligning Device)

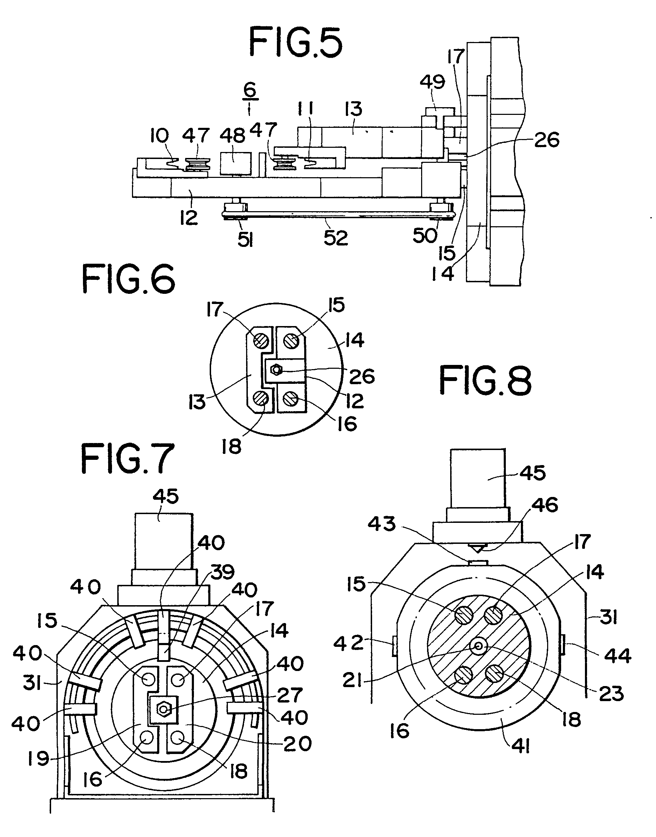

In Figs. 4 through 8, one of embodiments of an orientation-flat aligning device (6) is shown. This device has supporting arms (12), (13), which are faced opposite to each other and include receiving grooves (10), (11) to enable insertion of wafers (4) from side direction, and each of the supporting arms (12), (13) is respectively fixed by sliding shafts (15), (16) and (17), (18) inserted slidably throughout a body (14). Each of the sliding shafts (15), (16) and (17), (18) is respectively coupled with coupling boards (19), (20) at the rear end thereof. Inside of the body (14),bores (22), (23) which are connecting with a through hole (21) are provided, and piston rods (26), (27) of pistons (24), (25) inserted into the bores (22), (23) are respectively extended to the front or rear of the body (14). The front piston rod (26) is fixed to the base end of the supporting arm (12) (refer to Fig. 6). The rear piston rod (27) is fixed to the coupling board (20) being coupled with the rear end of the sliding shafts (17), (18) which operate another supporting arm (13) (refer to Fig. 7). When compressed air has been introduced into the through hole (21) through a hole (28), the pistons (24), (25) are moved outwardly (opposite direction from each other); namely, in Fig. 4, movement of the supporting arm (12) is to the left,and the supporting arm (13) to the right, and the distance therebetween extends. Thus, the supporting arms (12), (13) release the wafers being held between the receiving grooves (10), (11). Whereas, when compressed air has been introduced into the bores (22), (23) through the holes (29), (30), the pistons (24), (25) move inwardly (approaching direction) to each other, namely the supporting arm (12) moves to the right, and the supporting arm (13) to the left. As the result, distance between the supporting arms gets near to each other and returns to the state as illustrated in the drawing. In this state, when the wafer is inserted from the opening end of the receiving grooves, it is possible to hold and support the wafer between the receiving grooves.

The body (14) is supported rotatably with the frame (31) by means of bearings (32), (32) and is provided to enable rotation of 180 degrees by movement of the pulley (33) provided at the outer circumference thereof by means of a motor (34) through gears (35), (36), a pulley (37) and a toothed belt (38) provided on the frame (31). Ar the rear end of the body (14), a sensor plate (39) is provided. The movement of the sensor plate (39) is sensed by the sensors (40) provided at predetermined places, and thereby the motor (34) is controlled and the movement of the body is stopped in increments of 90 degree rotation (refer to Fig. 7). Further, on a flange (41) fixed on the body (14), receiving openings (42), (43), (44) for determining position are provided at 90 degrees interval. A stopper pin (46) located at the end portion of the rod of cylinder (45) provided on the frame (31), is inserted into the receiving openings (42), (43), (44) at each situation thereof and thereby the body is maintained at each place thereof so as to remain stationary (refer to Fig. 8).

In accordance with rotation of the body (14) in 90 degree increments, the supporting arms (12), (13) of wafers may vary their positions in three rotational positions, namely, the opening side thereof can be directed to the right and left sides in horizontal direction, and to the upward in vertical direction.

The supporting arms (12), (13) have grooved rollers (47), (47) for receiving wafers,and at the base portion of one of the supporting arms (12), a rotating roller (48) to rotate wafers is provided. The rotating roller (48) is rotated by means of a motor (49), pulleys (50), (51) and an endless belt (52) provided at the base portion of the supporting arm (12).

The orientation-flat aligning device (6) is constructed as mentioned above, thereby the supporting arms (12), (13) receive the wafers (4) therebetween when the supporting arms are directed either to the left or to the right. Thereafter, the supporting arms are rotated in such a manner that the opening side thereof moves upward by rotating the body (14). And, the rotating roller (48) is thus rotated by driving the motor (49), thence the wafers (4) periphery of which is in contact with the rotating roller (48), is driven rotationally, and the orientation-flat stops at the position opposed to the rotating roller (48) (refer to Fig. 4). Thereafter, the body (14) rotates in the reverse direction to the above, and when the opening side of the supporting arms turns sideways, the motor is stopped. Thus, the orientation-flat is aligned their position.

(Wafer Receiving Device)

Under the orientation-flat aligning device (6) is provided with a wafer receiving device (53) which receives the wafer from the above device and lowers it (refer to Fig. 3). The wafer receiving device has a holding unit (54) which holds the wafer by vacuum suction and a cylinder unit (55) which moves the holding unit (54) upward and downward. The holding unit (54) is attached to the rear surface of the wafer maintained in the orientation-flat aligning device, when the cylinder unit (55) is moving upward. In accordance with the operation to expand the space of the supporting arms (12), (13) of the orientation-flat aligning device, the wafer is transferred from the orientation-flat aligning device to the wafer receiving device. The holding unit (54) is lowered with holding the wafer.

(Carrying Means)

A carrying means (56) is provided to receive wafer from a holding unit of the wafer receiving device, when such holding unit is moved downward.

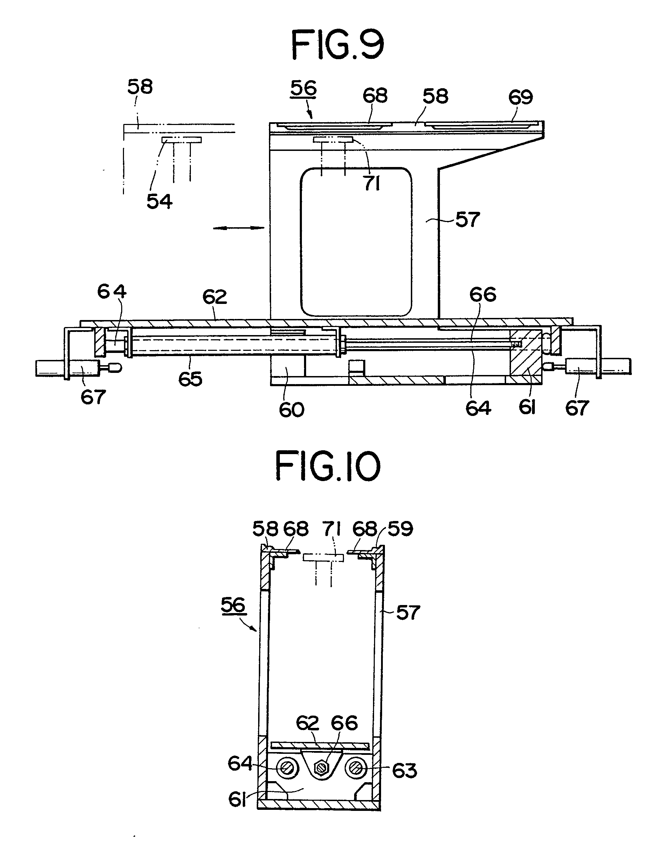

The carrying means is provided to enable alternate motion with placing wafer on their upper surface between a position for receiving the wafers, a position provided with an adhesive agent coating means and a position provided with 2 reverse chuck means, as mentioned hereinafter. The interval spaces between each of the above three positions are provided nearly equal distance apart. The carrying means may be provided in various types;in Figs. 9 and 10, rails (58), (59) are provided on a gate-like frame (57). The rails are of sufficient length to attain the position for receiving the wafers to the position provided with the adhesive agent coating means. The frame (57) having the rails (58), (59) forms base portions (60), (61) at the lower ends thereof respectively. The base portions (60), (61) are passed through downward under the body (62) and are inserted slidably with guide bars (63), (64) provided in the body (62). On the lower surface of the body (62), a cylinder unit (65) is installed and a rod (66) of the cylinder unit is fixed on the base portion (61). At the both ends of the body (62), shock absorbers (67), (67) are provided respectively, and the base portions (60), (61) of the frame abut thereto respectively.

On the upper surface of the rails (58), (59) are recesses (68), (69) which have a configuration corresponding to the outside diameter and the wafer is placed with being inlaid therein. The interval between the recesses (68), (69) is nearly equal with the interval between each of the above mentioned means.

In operation of the cylinder unit (65), the rails (58), (59) are moved alternately between the position showing full lines and the position showing chain lines in Fig. 9, and thus they can transfer the wafers received at the chain line position to the full line position.

(Coating of Adhesive Agent)

A coating section (3) which applies adhesive agent onto the wafers is constructed with a spin chuck means and an adhesive agent coating means as follows:

(Spin Chuck Means)

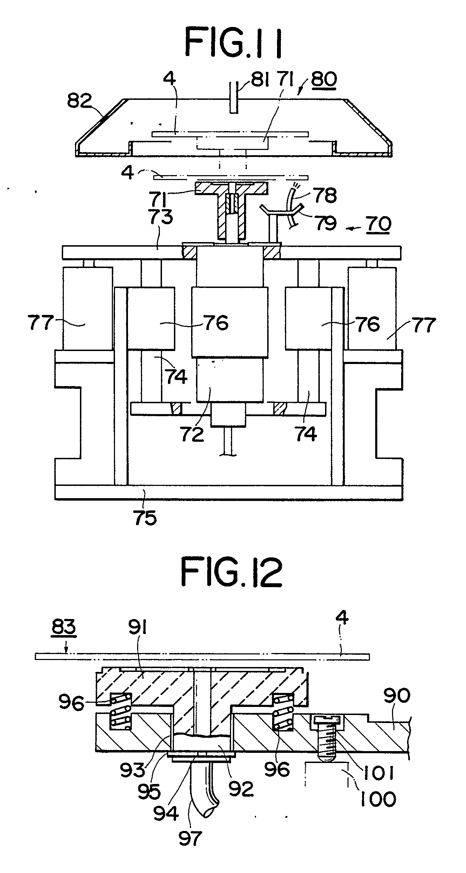

A spin chuck means (70) is provided to locate between the rails (58), (59) of the carrying means and the body (62) (refer to Fig.11). The spin chuck means has a holding part (71) which sucks the wafer placed between the rails (58), (59) utilizing vacuum suction and a motor (72) is provided on a frame (73) to rotate the holding part (71). The frame (73) has guide bars (74) and is supported to enable their upward and downward movement by passing through the guide bars (74) into bearings (76) provided in a body (75). In the body (75), cylinders (77), (77) are provided to permit the movement of the frame in upward and downward motion. When the cylinders (77), (77) are in motion, the holding part (71) moves upward and downward with the frame (73) through and between the rails (58), (59) of the carrying means.

On the upper surface of the frame (73), a nozzle (78) which permits to spray detergent such as acetone, etc., and a reservoir (79) which collects detergent flow from the nozzle, are preferably provided. The head of the nozzle (78) approaches the peripheral end of the wafer, when the holding part (71) holds the wafer, and rinses adhesive agent attached to periphery of the reverse side of the wafer with detergent. Utilizing this means, the post-washing after applying adhesive agent can be omitted.

(Adhesive Agent Coating Means)

On the upper side of the spin chuck means (70), a coating device (80) of the adhesive agent is provided. The coating device has a wax nozzle (81) which drips adhesive wax dissolved into an organic solvent, and a cover (82).

When the holding part (71) of spin chuck means (70) is elevated, the holding part holds by suction the wafer placed on the rails (58), (59) of the carrying means during upward movement. During the upward movement, the wafer is carried into an adhesive agent coating device (80). The wafer is turned its orientation by the holding part (71), and adhesive wax dripped from the wax nozzle (81) thinly coats the surface of wafer. Thereafter, the holding part (71) moves downward and the wafer coated adhesive agent is replaced on rails (58), (59) of the carrying means (56) during its downward movement.

(Reverse Chuck Means)

An adhesive section (1) which mounts the wafer coated adhesive agent on polishing plate is constructed as follows:

At a corresponding location in which the wafer finished coating of adhesive agent is carried, a reverse chuck means (83) is provided (refer to Figs. 12 - 14). The reverse chuck means (83) has a shaft (86) pivotable into bearings (85), (85) provided on an upper frame (84). The shaft (86) is jointed to a rotary actuator (87) and is rotatable from left to right in the range of nearly 180 degrees by controlling the operation of the rotary actuator (87) by sensors (88), (89). On the shaft (66), an arm (90) is fixed, and at the head of the arm (90), a holding unit (91) is provided to hold the wafer (4) by suction. As shown in Fig. 12, the holding unit (91) is preferably made of heat-proof material such as ceramic, so that it can fix the wafer properly by the heat of the above polishing plate (112) without distorting the holding unit (91). In case it is not necessary to consider the effect of the temperature, the holding unit (91) can be made of metallic material. The holding unit (91) has a fitting shaft (92) on the rear side. Fitting shaft (92) is inserted loosely into a fitting hole (93) provided at the end portion of arm (90) and is prevented to slip out by inserting a stop ring (95) into an annular slot (94) formed in the fitting shaft (92). Further, between the holding unit (91) and the arm (90), a spring (96) is provided, and it biases the holding unit (91) to the direction of keeping apart from the arm. A suction pipe (97) extending to the holding unit (91) is connected to the shaft (86) and further connected to the vacuum suction source (not illustrated) from side of the shaft. At the side of the arm, a shock absorber (98) is provided and when the arm (90) is reversed, a flange (99) provided at the side of the arm abuts to the shock absorber. Further, in the position showing in the drawing, the arm (90) abuts to a stopper (100) and the stopper substantially maintains the holding unit (91) in the horizontal direction with its upward orientation. An inclination of the holding unit (91) can be adjusted by a screw (101).

The upper frame (84) has guide bars (102) extending downward and is supported to be movable upward and downward by inserting the guide bars (102) through a moving frame (103). On the moving frame (103), a cylinder unit (104) is provided, and by operating the cylinder unit (104), the upper frame (84) is moved upward or downward.

At the lower part of the moving frame (103), a body (105) is provided. On the body (105), the moving frame (103) is assembled slidably through bearings (107), (107) to a guide shaft (106) provided on the body. A cylinder unit (108) provided in the body (105) is connected to the lower portion (110) of the moving frame (103) by a piston rod (109) thereof. By operating the cylinder unit (108), the moving frame (103) and the upper frame (8k406).

Thus, the reverse chuck means (83) is provided so that the holding unit (91) thereof is located under and between the rails (58), (59) of the carrying means (56), when the holding unit (116) is turned upward as shown in the drawing. The carrying means stops when the wafer (4) placed on the rails comes to the position just above the head of the holding unit (91). At the side on the near portion of wafers, a heating means (III) such as infrared lamp, etc. is provided to evaporate organic solvent such as acetone, etc. of adhesive agent. Exclusion of organic solvent may be possible by that as mentioned hereunder, when the wafer approaches the heated polishing plate in accordance with rotation of the arm, the movement of the arm stops for a few seconds and transmits heat of the polishing plate to the wafer.

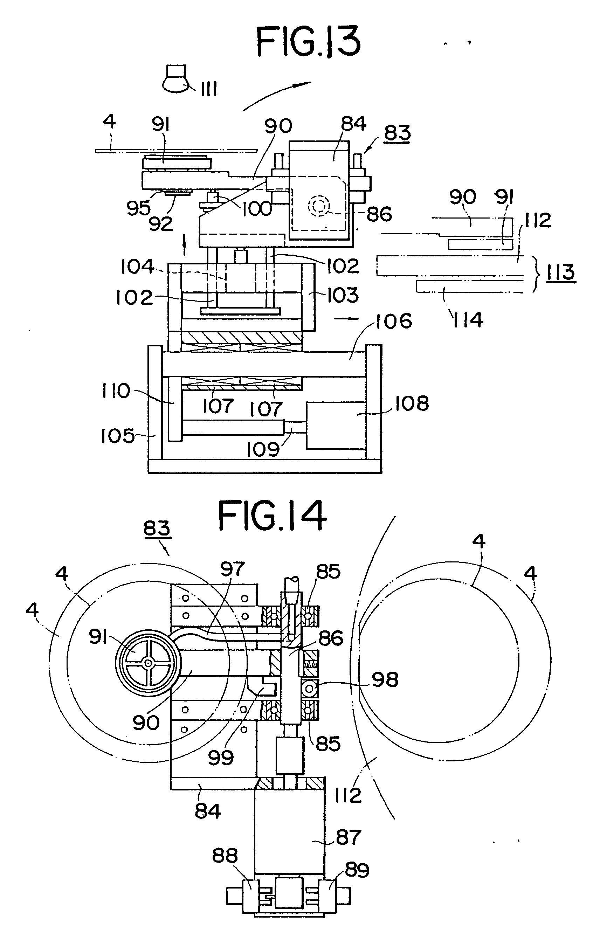

When the wafer (4) is at the position mentioned above, the upper frame (84) moves upward slightly by means of operation of the cylinder unit (104), and the holding unit (91) absorbingly holds the wafer (4) and takes the wafer from the carrying means. When the rotary actuator (87) is in motion, the arm (90) rotates and the holding unit (91) reverses sides of the wafer (4) and adheres such wafer on the polishing plate (112) (refer to chain lines in Fig. 13). At the time of adherence of the wafer to the polishing plate, the cylinder unit (104) operates and descends the upper frame (84). By this operation, the wafer is securely adhered to the polishing plate. After adhering of the wafer, the rotary actuator (87) returns the arm (90) to the reverse side,and accordingly the holding unit (91) returns to its former position as shown in drawings and is prepared for reversing and adhering the next wafer.

Even if the sizes of wafers are different, e.g., 4, 5 and 6 inches, etc. the moving frame (103) is transferred by the cylinder unit (108) so that the position of orientation-flat is almost the same level of the polishing plate (112). Namely, the holding unit (91) is in the above mentioned waiting position for holding the center of the wafer,and accordingly when the arm (90) rotates, the moving frame (103) is transferred to the polishing plate (112) corresponding to the size of wafer and adheres the wafer onto the polishing plate. The wafer can be adhered to the orientation-flat at the predetermined place of the polishing plate.

(Polishing Plate Holding Means)

A polishing plate is held by a dividing means. The dividing means (113) as shown in Fig. 2 as a dividing plate (114) at the upper portion thereof, indexes the position of the polishing plate (112) placed on the upper surface thereof by rotating the dividing plate (114) by means of a step motor (115), receives and adheres the wafer from the reverse chuck means as mentioned above at the predetermined position of the polishing plate. Further, when placing the polishing plate (112) on the dividing plate (114), it is centered. Above dividing plate (114), a heating means (116) such as a far-infrared heater, etc. is provided, and the dividing plate (114) is kept at a predetermined temperature.

In order to adjust the adhering position of the polishing plate and the wafer, the dividing means can be provided to enable its movement in a longitudinal direction (i.e, in the direction approaching to or separating from the reverse chuck means) corresponding to the sizes of the polishing plate and/or the wafers. Solvent remaining on the wafer is evaporated by means of a heating means (116) on the polishing plate provided near to the dividing plate.

At the above portion of the dividing means, a stamp means (117) is provided to press the wafer mounted on the polishing plate. The stamp means (117) has a pad (118) made of a special rubber or other elastic materials at the lower surface thereof, and presses the wafer (4) to the polishing plate (112) by moving the pad (118) with a cylinder unit (119).

(Explanation of Whole Process)

Continuous operations of each means mentioned above can be explained generally as follows:

In Figs. 1 and 2, an orientation-flat aligning device (6) receives the wafer (4) in the position that the holding arms (12), (13) are faced sideways, moves upward the holding arms so that they turn to the upright position, and determines the situation of orientation-flat of the wafer. Thereafter, returning the holding arms to the original position, moving upward the holding unit (54) of the wafer receiving device (53) from the lower position, and sucking the wafer on the upper surface of the holding unit (54), and then receiving and supporting the wafer on the holding unit (54) by opening each of the holding arms (12), (13) to the left and right. When the orientation-flat of the wafer is set in the cassette, the orientation-flat aligning device can be omitted, and such the wafer directly to the holding unit.

The holding unit (54) of the wafer receiving device moves downward after receiving the wafer (4) and during the downward movement, places the wafer on the left side shown in the drawing on the rails (58), (59) of the carrying means (56).

The rails (58), (59) of the carrying means (56) which receive the wafer, move to the right side in the drawing, and carry the wafer upper the spin chuck means (70). The holding unit (71) of the spin chuck means (70) elevates and holds the wafer, and carries it into the adhesive agent coating device (80). Therein, adhesive agent is dripped onto the water which is rotating or remains stationary. In the latter case, the wafer is rotated after dripping. Thus, adhesive agent is uniformly applied to the upper surface of the wafer.

In the meantime, the rails (58), (59) of the carrying means (56) move to the left in the drawing, and receive the next wafer.

After applying adhesive agent, the holding unit (71) of the spin chuck means (70) is moved downward, and places the wafer with adhesive agent at the right side in the drawing on rails (58), (59) of the carrying means (56).

Again, the rails of the carrying means (56) move to the right and the wafer applied adhesive agent and placed on the right part is carried to the upper position of a holding unit (91) of the reverse chtuck means (83) (refer to chain line in Fig. 2). At that time, another new wafer placed at the left portion of the rails is carried on the upper position of the spin chuck means as mentioned above.

The holding unit (91) of the reverse chuck means (83) is elevated upward and receives the wafer applied with adhesive agent from the carrying means, and adheres the wafer on the polishing plate (112) by rotating arm (90). Thereafter, the holding unit (91) is moved downward and the arms are returned to its original position.

The stamp means (117) located above the polishing plate (112) moves downward to the upper surface of the wafer adhered on the polishing plate and becomes pressed such wafer, and moves upward.

As mentioned above, after adhering the wafer at the predetermined place of the polishing plate, the stop motor (115) of the dividing means (113) operates and rotates the dividing plate (114) to the next position in which a new wafer is to be attached.

Thus, after the required sheets of wafer have been adhered on the polishing plate, the polishing plate is carried to the press cooling position by the robot, and a new polishing plate is placed by the robot on the upper surface of the dividing plate (114) of the dividing means (113). The above mentioned operations are repeated and adhere the wafer on the polishing plate at full automation. As for a polishing plate, the flat upper surface is shown in the drawings, but if required, the polishing plate may be formed narrow grooves lengthwise and crosswise, etc. on the surface thereof. Further, the narrow holes may be provided at the place on which the wafer is attached. These grooves or holes are useful, to escape air in adhesive agent.

The present invention may be embodied in other specific forms without departing from the spirits or essential characteristics thereof. For example, the above mentioned reverse chuck means (83) is constructed to enable to eject the wafers from the carrying means and to reverse the wafer during its transference. Instead of the above constitution, it is possible to be constructed that the reverse chuck means ejects the wafers from the carrying means, and after transferring it in the direction of a polishing plate and reaching the polishing plate, reverses the side of the wafer on the polishing plate.

Further, the holding unit of the reverse chuck means, etc. in the present invention, holds the wafer by sucked operation, but it is possible to hold it by hooks or other suitable means. Further, the above chuck means rotates arms provided in the holding unit 180 degrees around the shaft (86), and angle of the rotation may be changed if desired. Further, it is possible to provide rotatably the holding unit with an axis of the arms, rotate the holding unit axially and reverse the sides of the wafer.

The present invention is constructed as mentioned above and accordingly the wafer can be adhered effectively in full automation. Thus, the present invention is useful in the polishing working of the wafer of silicon, gadolinium, gallium, garnet, gallium arsenide, sapphire, crystal, glass, ceramics, etc.

## Claims

1. A device automatically adhering wafers on the polishing plate comprising:
a carrying means which transfers wafers and puts thereon one by one,
a spin chuck means which is provided to permit up or down movement, receiving wafers from the carrying means during the upward movement, turning wafers at the top position, and replacing wafers to said carrying means during the downward movement,
an adhesive agent coating means which is provided at the upper portion of said spin chuck means and drips said adhesive agent thereupon to said wafers,
a reverse chuck means which inverts the side of wafers on which adhesive agent is coated and removed outwardly said waters from the carrying means, and
a means for holding the polishing plate at the predetermined place so as to adhere the wafer ejected from said carrying means in reversed position onto the surface of said polishing plate.

2. A wafer adhering device in accordance with claim 1, wherein said carrying means is movable alternatively between the position for receiving the wafers, the position provided with said adhesive agent coating means, and the position provided with said reverse chuck means.

3. A wafer adhering device in accordance with claim 2, wherein spaces between each of positions for receiving the wafers and the position provided with the adhesive agent coating means, and spaces between the latter position and the position provided with the reverse chuck means are provided nearly equal distance apart.

4. A wafer adhering device in accordance with claim 1, wherein said reverse chuck means reverses the wafer during its transference.

5. A wafer adhering device in accordance with claim 1, wherein the wafer holding part of said reverse chuck means is made of heat-proof material.

6. A wafer adhering device in accordance with claim 1, wherein said wafer is placed on the carrying means under aligning the situation of orientation-flat of the wafer.

7. A wafer adhering device in accordance with claim 1, wherein said polishing plate is held to the holding means under the heated condition.

8. A wafer adhering device in accordance with claim 7, wherein said polishing plate is gradually heated.

9. A wafer adhering device in accordance with claim 1, wherein said polishing plate is transferred onto the holding means by the robot, and after mounting the wafer, said plate is transferred by the robot therefrom.

10. A wafer adhering device in accordance with claim 1, wherein said holding means includes a stamp means to press the wafer mounted on the polishing plate.

11. A wafer adhering device in accordance with claim 1, wherein said polishing plate has narrow grooves or small holes on the surface thereof.

12. A wafer adhering device comprises a holding means for holding wafers with facing upwardly the adhesive coated surface of the wafer , rotatable arms having said holding means at their free end, said arms being characterized to adhere the wafers to the polishing plate, turning over said holding part upon the rotation of said arms.

13. A wafer adhering device in accordance with claim 12, wherein said holding means are made of heat-proof material.

# FIG. 1

# FIG. 2

# FIG.3

# FIG.4

# FIG.5

6

# FIG.6

# FIG.8

# FIG.7

# FIG.9

# FIG.IO

# FIG.11

# FIG.12

# FIG.13

# FIG.14